# EUROPEAN PATENT SPECIFICATION

(11) **EP 4 716 768 B1**
(45) Date of publication and mention of the grant of the patent: **14.10.2026**
(21) Application number: 25750362.3
(22) Date of filing: 04.08.2025
(51) Int. Cl.: C25B 1/04, C22C 14/00, C23C 14/00, C25B 9/65, C25B 11/063

(54) **ELECTRICALLY CONDUCTIVE AND CORROSION-RESISTANT COMPOSITE COATINGS**
ELEKTRISCH LEITFÄHIGE UND KORROSIONSBESTÄNDIGE VERBUNDBESCHICHTUNGEN
REVÊTEMENTS COMPOSITES ÉLECTROCONDUCTEURS ET RÉSISTANTS À LA CORROSION

(30) Priority: 05.08.2024 WO PCT/CN2024/109835; 23.08.2024 EP 24196141
(43) Date of publication of application: 01.04.2026
(73) Proprietor: Nanofilm Technologies International Limited, Singapore 535226 (SG)
(72) Inventor: WANG, Ting, Shanghai 201703 (CN); FU, Xiuqi, Shanghai 201703 (CN); LIU, Yahui, Shanghai 201703 (CN)
(74) Representative: Schlich
(86) International application number: PCT/EP2025/072408
(87) International publication number: WO 2026/032931

(56) References cited:
- CN-A- 113 584 441
- CN-A- 115 411 285
- CN-B- 109 735 869
- CN-B- 114 561 622

## Description

### Introduction

The present invention relates to coatings that are electrically conductive and also possess corrosion-resistant properties, as well as methods of making and using such coatings. The coatings are considered to be particularly useful in components of electrolysers and specifically, bipolar plates, current collectors and porous transport layers.

### Background to the Invention

An increasing awareness of the effects of climate change has led to an increase in research on alternative "fossil free" energy sources, such as hydrogen.

Proton exchange membrane (PEM) electrolyser technology has the advantages of compact structure, fast response, high current density and adaptability. Therefore, hydrogen production by PEM water electrolysis is an important technical path for hydrogen production in the future.

Bipolar plates, current collectors and porous transport layers (PTL) are important components of PEM electrolysers. The environment on the anode side of PEM electrolysers is relatively harsh (and includes high temperatures of around 60-80°C, strong acidic environments of about pH 2, high voltages of around 1.4V-2V and the presence of oxygen species). The surfaces of untreated bipolar plates and porous transport layers therefore oxidize easily, leading to an increase in contact resistance. This affects the overall operation efficiency of the PEM electrolyser.

At present, in order to solve this problem, precious metal materials such as platinum, gold or iridium oxide are coated on the surface of metallic bipolar plates and porous transport layers to improve their conductivity and corrosion resistance. However, noble metal coatings are relatively expensive, which limits the development of PEM electrolysers. Therefore, the research and development of non-precious metal coatings with high conductivity and high corrosion resistance is an important means to reduce costs and improve the service life of electrolysers.

CN114214658A describes a coating deposited by magnetron sputtering deposition, in which the conductivity test results show that the initial contact resistance of the coating is greater than 3.5mΩ•cm² at 1.5MPa.

CN114990605A describes a coating comprising a transition metal nitride, as well as an oxide. The conductivity and corrosion resistance of various coatings are compared, among which the initial contact resistance is greater than 3mΩ•cm² at a pressure of 1.5MPa.

CN115710713A describes a coating comprising doped metal oxides. The deposition of this coating takes place by high-temperature (400-1000°C) PVD combined with evaporation, which is relatively complex, and the product preparation cost is high.

CN113584441A describes a metal bipolar plate coating and preparation method thereof. The coating described therein includes an underlayer, an anti-oxidation layer, and a noble metal doped layer deposited sequentially on a substrate.

CN109735869B describes a corrosion-resistant conductive alloy film layer and a preparation method thereof, wherein the alloy film layer is co-deposited from Ti and Nb.

As discussed above, some prior art coatings prepared by magnetron sputtering generally have a large initial contact resistance and poor conductivity. Other prior art coatings require high-temperature deposition processes, which are complex and have high energy consumptions for industrial applications. In addition, while precious metal coatings can be used, these are expensive.

There therefore exists the need for alternative coatings for electrolysers which exhibit good corrosion-resistant properties and preferably are more economical than currently available solutions.

### Summary of Invention

The present invention provides composite coatings with high conductivity and high corrosion resistance, which can be applied to electrolyser components to reduce the operating cost of a proton exchange membrane (PEM) water electrolyser and improve its service life.

Accordingly, the invention provides a coated substrate comprising in order:
a) a substrate
b) a seed layer comprising Ti or oxides thereof;
c) one or more corrosion-resistant layers comprising Ti, Nb or oxides thereof, each layer comprising first, second and third wherein the amount of Ti increases from the first to the third sublayer and the amount of Nb decreases from the first to the third sublayer;
d) a conductive layer comprising Nb, or nitrides and/or oxides thereof.

As shown in the examples below, the coatings of the invention possess excellent conductivity and corrosion resistance.

The present invention avoids the use of precious/noble metals, which reduces production costs. In addition, the coating can be applied using a low-temperature deposition process, such as magnetron sputtering.

The coatings can be applied on bipolar plates, porous transport layers (PTL), and current collectors of water electrolysis devices.

The invention also provides a method of making a coated substrate (such as a coated substrate as described herein), the method comprising depositing onto a substrate in order:
a) a seed layer comprising Ti or oxides thereof;
b) one or more corrosion-resistant layers comprising Ti, Nb or oxides thereof, each layer comprising first, second and third sublayers, wherein the amount of Ti increases from the first to the third sublayer and the amount of Nb decreases from the first to the third sublayer;
c) a conductive layer comprising Nb, or nitrides and/or oxides thereof.

### Details of the Invention

As described above, the coating imparts good corrosion resistance and electrical conductivity to the coated substrate. The coating may therefore find uses in a number of applications. However, a specific application in which the coating may be used is in components for electrolysers (specifically proton exchange membrane (PEM) electrolysers).

Various components of PEM electrolysers are exposed during use to harsh conditions, such as high-potential and acidic environments, which may cause corrosion. Examples of such components are bipolar plates, current collectors, porous transport layers (PTL) and gradient Ti meshes. Such components are typically formed from titanium.

The substrate may also be formed of other materials from which bipolar plates (or other PEM electrolyser components) are typically made. The substrate is also typically one which is susceptible to corrosion. For example, the substrate may be a metallic substrate. When the substrate is metallic, the substrate may be formed of a single metal or be formed from an alloy (e.g. an alloy of iron, titanium or aluminium). Preferably the substrate is a titanium substrate, as titanium is a common material used for electrolysers. The substrate may also be a steel substrate, preferably stainless steel, such as a SUS304 or 316L stainless steel substrate, which is commonly used in the manufacture of bipolar plates for PEM electrolysers. SUS301 and SUS303 stainless steel may also be suitable for use as the substrate.

The size of the metallic substrate will of course depend on the purpose of the substrate. For bipolar plates used in electrolysers, the substrate (i.e. not including the coating) will typically have a thickness of a few millimeters, for example 2mm or less, 1.5 mm or less, for example preferably approximately 1mm. The bipolar plates may have flow field channels on the surface or may be a flat metal sheet with profiled insert parts such as Ti meshes providing the channel structure.

As described above, the coatings comprise sequentially from the substrate: a seed layer, one or more corrosion-resistant layers, each with multiple sublayers, and a conductive layer.

Herein, the term "transition metal" refers to an element whose atom possesses an incompletely filled d orbital or which forms one or more stable ions with incompletely filled d orbitals, in accordance with the present IUPAC definition for the term. In some embodiments, the transition metal is a first- or second-row transition metal.

The seed layer comprises Ti and optionally one or more transition metal elements. For example, the seed layer may comprise Ti and one or more elements selected from Sc, Zr, Nb, W, Ta, V, Hf, Cr and Mo. The seed layer may also comprise alloys and/or oxides of these transition metals. Typically, the seed layer comprises Ti and one or more metals selected from Ta, Nb, Zr, W and oxides thereof. The seed layer may consist of oxides of Ti, Nb or combinations thereof and thus comprise Ti, Nb and O. In many of the examples described herein, the seed layer is a titanium-niobium oxide layer comprising Ti, Nb and O.

When present, the percentage of oxygen atoms in the seed layer may range from 1% to 20%, for example from 5% to 15%. When the seed layer comprises Ti, Nb and O, the atomic percentages are typically as follows: the percentage of Ti atoms in the seed layer usually ranges from 20% to 70%, such as 30% to 60% and/or the percentage of Nb atoms in the seed layer usually ranges from 15% to 65%, such as 25% to 55%.

When oxygen is not present in the seed layer and the seed layer comprises Ti and Nb, the percentage of Ti atoms in the seed layer usually ranges from 30% to 80%, such as 40% to 70% and/or the percentage of Nb atoms in the seed layer usually ranges from 20% to 70%, such as 30% to 60%.

The atomic content can be measured by energy dispersive spectrometer (EDS) of an electron microscope. Other methods of quantitative measurements include electron energy loss spectroscopy (EELS) and X-ray photoelectron spectroscopy (XPS).

The seed layer typically has a thickness of 10nm or greater, such as 20nm or greater, preferably 50nm or greater or 80nm or greater. The thickness of the seed layer is typically 3000nm or less, such as 1500nm or less, preferably 1000nm or less or 800nm or less. Accordingly, the thickness of the seed layer may be from 10nm to 3000nm, for example from 20nm to 1000nm, such as from 20nm to 800nm.

The seed layer may serve to promote adhesion of the substrate and the corrosion-resistant layer(s). Accordingly, the seed layer may be directly adjacent to the substrate and/or be directly adjacent to the corrosion-resistant layer (or the lowermost corrosion-resistant layer when there is more than one).

The seed layer may also impart some corrosion-resistant properties to the overall coating and therefore deposition of the seed layer should ensure that as much of the substrate is covered as possible. The seed layer is preferably deposited to be high density. The seed layer may therefore be deposited using a variety of physical vapour deposition (including sputtering), plasma vapour deposition or chemical vapour deposition techniques.

The coating further comprises a conductive layer. The conductive layer is typically the uppermost layer of the coating to provide the coated substrate with a conductive surface and thereby enable it to perform its function, e.g. in a PEM electrolyser.

The conductive layer comprises Nb and optionally one or more transition metal elements. For example, the conductive layer may comprise Nb and one or more elements selected from Sc, Ti, Zr, W, Ta, V, Hf, Cr and Mo. The conductive layer may also comprise alloys, nitrides and/or oxides, and/or oxynitrides of these transition metals. Typically, the conductive layer comprises Nb and one or more metals selected from Ti, Ta, Zr, W and nitrides and/or oxides and/or oxynitrides thereof. Preferred additional materials for the conductive layer are Ti, and nitrides and/or oxides and/or oxynitrides thereof. Accordingly, the conductive layer may consist of Ti, Nb, nitrides, oxides and oxynitrides of Ti and/or Nb. The conductive layer may comprise a mixture of Ti, Nb, N and O. In many of the examples described herein, the conductive layer is a layer comprising Ti, Nb, N and O.

The atomic percentages of the first transition metal in the conductive layer are between 30% to 60%, preferably between 35% to 55%, for example between 40% and 50%.

The atomic percentages of the second transition metal in the conductive layer are between 1% and 35%, preferably between 5% and 30%, for example between 10% and 25%.

The nitrogen content of the conductive layer may be between 1% and 60%, preferably such as 5% and 50%, and most preferably between 10% and 40%.

The oxygen content of the conductive layer may be between 1% and 40%, such as 5% and 35%, and most preferably between 10% and 30%.

Although the conductivity of pure nitride films may be higher, their surfaces may be more easily passivated, which leads to reduced conductivity. The addition of oxygen atoms to the conductive layer can be used to improve the corrosion resistance of the conductive layer while maintaining conductivity.

The conductive layer typically has a thickness of 50nm or greater, such as 80nm or greater, preferably 100nm or greater or 200nm or greater. The thickness of the conductive layer is typically 3000nm or less, such as 2500nm or less, preferably 2000nm or less or 1500nm or less. Accordingly, the thickness of the conductive layer may be from 50nm to 3000nm, for example from 100nm to 2000nm, such as from 200nm to 1500nm.

The conductive layer is typically directly adjacent to the corrosion-resistant layer (or the uppermost corrosion-resistant layer when there is more than one).

The coatings of the invention comprise one or more corrosion-resistant layers, wherein each layer comprises a first, a second and a third sublayer. Each of the sublayers comprise Ti as the first transition metal, which is also present in the seed layer, as well as Nb as the second transition metal, which is also present in the conductive layer.

The first (Ti) and second (Nb) transition metals are preferably different from each other. However, this, of course, does not preclude the second transition metal being present in the seed layer (as well as the first transition metal) and/or the first transition metal being present in the conductive layer (as well as the second transition metal). What is important is that there is a first common transition metal between the seed layer and the corrosion-resistant layer(s) and a second (different) transition metal that is common between the corrosion-resistant layer(s) and the conductive layer.

As described above, the first and second transition metals are titanium and niobium respectively. However, the corrosion-resistant layers may comprise other transition metals, including Sc, Zr, W, Ta, V, Hf, Cr, Mo and/or their nitrides and carbides. Preferred additional transition metals that may be present in the corrosion-resistant layer(s) are Ta, Zr and W, including their nitrides and carbides. Preferred materials for the corrosion-resistant layer are selected from Ti, Nb and nitrides and/or carbides thereof.

The ratio of the first transition metal to the second transition metal increases from the first (i.e. the lowermost) sublayer to the second sublayer and then increases further from the second sublayer to the third (uppermost) sublayer.

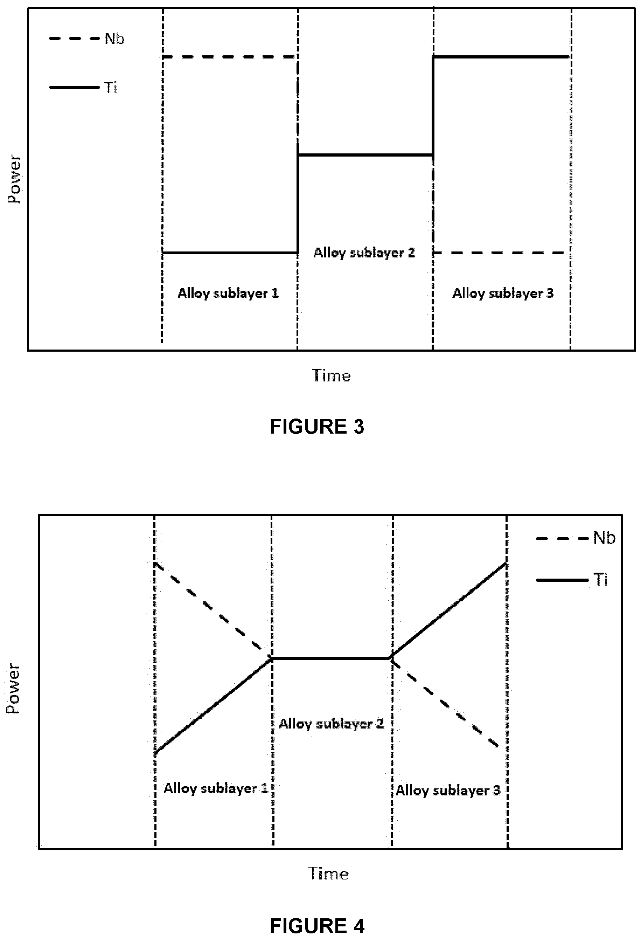

The change in the ratio of the first to second transition metals may occur step-wise across the sublayers. In other words, the ratio of the first and second transition metals is constant within each sublayer, but there is a change in the ratio between adjacent sublayers. Figure 3 shows the power of two sputtering transition metal targets against time during the deposition of a corrosion-resistant layer having such a step-wise transition across sublayers. In Figure 3, the first transition metal is Ti, and the second is Nb. The power of Ti sputtering is shown to increase in a stepwise fashion from alloy sublayer 1 to alloy sublayer 3, indicating that the Ti content increases from alloy sublayer 1 to alloy sublayer 3. Meanwhile, the power of Nb sputtering decreases stepwise from alloy sublayer 1 to alloy sublayer 3, indicating a decrease in Nb content from alloy sublayer 1 to alloy sublayer 3. As a result, the Ti:Nb ratio varies across the sublayers in a step-wise manner.

Alternatively, the ratio of the first and second transition metals may vary across the thickness of each sublayer, as well as changing between sublayers. In other words, the ratio of the first and second transition metals at the bottom of the sublayer may be different to that of the top of the sublayer. For example, the content of the first transition metal in the sublayer may progressively increase or decrease while the content of the second transition metal in the sublayer progressively decreases or increases across the thickness of the sublayer. As described above, between different sublayers the ratio of the first and second transition metals also changes. In this arrangement, there is a gradual transition in the ratio of the first and second transition metals across the thickness of each of the sublayers.

Figure 4 shows the power of two sputtering transition metal targets against time during the deposition of a corrosion-resistant layer having a gradual transition across sublayers. In Figure 4, the first transition metal is Ti while the second transition metal is Nb. The power of Ti sputtering is shown to increase gradually across alloy sublayer 1 and alloy sublayer 3, indicating that the Ti content is gradually increasing across alloy sublayer 1 and alloy sublayer 3. Meanwhile, the power of Nb sputtering is shown to decrease gradually across alloy sublayer 1 and alloy sublayer 3, indicating that the Nb content is gradually decreasing across alloy sublayer 1 and alloy sublayer 3. Much like Figure 3, Figure 4 shows an overall change in the Ti:Nb ratio across the sublayers.

By employing variable power deposition using high, medium and low power for the first transition metal (Ti) and the second transition metal (Nb) across the sublayers of the corrosion-resistant layer(s), as shown in Figures 3 and 4, the main element of the alloy in each sublayer of each corrosion resistant layer can be finely tuned and controlled. This helps to better define the properties of each sublayer within the corrosion-resistant layer and ensures that the corrosion-resistant layer as a whole exhibits the characteristics of both the first and second transition metals.

Typically, embodiments of the invention that involve step-wise transition across sublayers and embodiments of the invention that involve gradual transition across sublayers both contain a central (i.e. second) sublayer that contains a constant ratio of the first and second transition metals.

In one embodiment, the ratio of the first and second transition metals varies across the thickness of the first and third sublayers but is consistent throughout the second sublayer. Figure 4 shows the power of two sputtering transition metal targets against time during the deposition of a corrosion-resistant layer having such a transition across sublayers.

The ratio of the first and second transition metals within the sublayers can be controlled by varying the power of magnetron sputtering targets. By forming different sublayers (using variable power deposition), the nature of the corrosion-resistant layer transitions from being more electrically conductive to more corrosion-resistant. This achieves corrosion resistance and high electrical conductivity at the same time.

It is described above how each corrosion-resistant layer comprises 3 sublayers. However, it will be appreciated that further sublayers may be present. For example, each corrosion-resistant layer may comprise 4, 5, 6 or more sublayers. Regardless of the number of sublayers, the ratio of the first and second transition metals varies between the sublayers and preferably increases/decreases from the lower to the upper sublayer (or vice versa) as described above.

Configuring each corrosion-resistant layer to comprise 3, 4, 5, 6 or more sublayers allows for a gradual or stepwise transition of the main alloy component from the second transition metal to the first transition metal. This allows each corrosion-resistant layer to have the characteristics of both transition metals, thereby ensuring good corrosion resistance and high electrical conductivity in the coating of the present invention.

Typically, in coatings of the present invention, the hardness of the corrosion resistant layer increases from the first (bottom) sublayer to the third (top) sub-layer. This is achieved by transitioning the main alloy component from a transition metal with lower hardness (Nb) to a transition metal with greater hardness (Ti). The first (bottom) sub-layer of the corrosion resistant layer directly connected to the seed layer preferably comprises a less-hard alloy typically formed from Ti and Nb, wherein the primary alloy component is preferably Nb. The third (top) sub-layer directly connected to the conductive layer preferably comprises a harder alloy typically formed from Ti and Nb, wherein the primary alloy component is preferably Ti.

The proportion of the first transition metal (Ti) in the third (top) sublayer is greater than in the first (bottom) sublayer. This causes the third (top) sublayer to possess increased hardness (relative to the first sublayer) and improves adhesion of the third (top) sublayer to the conductive layer. Likewise, the proportion of the second transition metal (Nb) in the first (bottom) sublayer is greater than in the third (top) sublayer. This causes the first (bottom) sublayer to possess reduced hardness (relative to the third sublayer) and improves adhesion of the first (bottom) sublayer to the seed layer.

The overall coating hardness is typically in the range of 100 - 1000 HV, preferably 200 - 500 Hv and most preferably 300 - 400 HV. The hardness values (HV) are measured according to ASTM E2546 nanoindentation standards.

The ratio of the first (Ti) and second (Nb) transition metals in sublayer 1 may be between 0.2:1 to 0.9:1, preferably from 0.3:1 to 0.8:1.

The ratio of the first (Ti) and second (Nb) transition metals in sublayer 2 may be between 0.5:1 to 1.8:1, preferably from 0.6:1 to 1.3:1.

The ratio of the first (Ti) and second (Nb) transition metals in sublayer 3 may be between 0.9:1 to 5:1, preferably from 1:1 to 4:1.

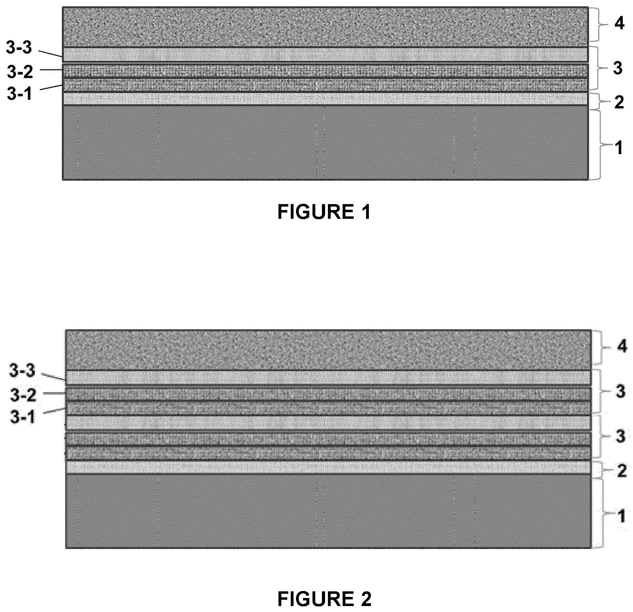

The coating may comprise two or more corrosion-resistant layers (as shown in Figure 2), wherein each corrosion-resistant layer comprises three sublayers in the manner described above. The use of multiple corrosion-resistant layers can help avoid the formation of columnar structures within the coating, which can be caused by the thickness of a single film layer and affect the susceptibility of the coating to corrosion.

Columnar structures tend to form more readily and become more pronounced in thicker, single-layer coatings. By dividing each corrosion-resistant layer into distinct sub-layers in coatings of the present invention, the likelihood of columnar structures formation is reduced and any columnar structures that form are smaller and able to extend through a lower proportion of the corrosion-resistant layer. This reduces the development of void networks formed by the columnar structures and thereby improves the corrosion resistance of the coating.

It will be appreciated that in certain embodiments of the invention comprising two or more corrosion-resistant layers, an interface is formed between the top (third) sub-layer of a first corrosion-resistant layer and the bottom (first) sub-layer of a second corrosion-resistant layer.

As described above, the first transition metal (Ti) content in each sub-layer increases from the first (bottom) to the third (top) sub-layer in each corrosion-resistant layer. Consequently, the interface between adjacent corrosion-resistant layers preferably involves a transition between the third (top) sub-layer of a first corrosion-resistant layer with a greater proportion of a first transition metal with higher hardness and corrosion resistance (Ti) and the adjacent first (bottom) sub-layer in an adjacent second corrosion-resistant layer with a lower proportion of the first transition metal but a greater proportion of a second transition metal with lower hardness and corrosion resistance but greater electrical conductivity (Nb). This interface between corrosion-resistant layers in the invention contributes to reducing interfacial contact resistance, thereby enhancing the electrical conductivity of coatings according to the present invention.

Preferably, the proportion of the second transition metal (Nb) in the first (bottom) sub-layer of the first corrosion-resistant layer is lower than the proportion of the second transition metal (Nb) in the first (bottom) sub-layer of the second corrosion-resistant layer. Preferably, there is an overall greater proportion of Nb in the second corrosion-resistant layer relative to the first corrosion-resistant layer. This causes the second corrosion-resistant layer to have greater electrical conductivity than the first corrosion-resistant layer. In specific embodiments of the invention comprising two or more corrosion-resistant layers, preferably, the proportion or amount of Nb increases in subsequent corrosion-resistant layers from the first (bottom) corrosion-resistant layer to the top corrosion-resistant layer.

Each sublayer within the corrosion-resistant layer typically has a thickness of greater than 10nm, for example greater than 20nm. The maximum thickness of each sublayer is generally up to 1500nm, preferably up to 1000nm, such as up to 500nm or up to 250nm. Accordingly, each sublayer may have a thickness of from 10nm to 1000nm, for example from 20nm to 500nm, preferably from 20nm to 250nm.

In some examples, each sublayer within the corrosion-resistant layer will have the same thickness. In other examples, the thickness of the second sublayer is less than that of the first sublayer and/or the thickness of the third sublayer is less than the thickness of the second sublayer.

The deposition rate of different transition metals varies even with the same power of sputtering. The time duration for sputtering each sublayer can be the same or different, depending on the deposition rate of the metals used and the preferred thickness of each sublayer. When each sublayer is sputtered with the same time duration, the thickness of sublayer 1 to sublayer 3 may increase or decrease depending on the combination of transition metals and the nature of their deposition rates.

For example, with the same sputtering power, the deposition rate of Ti is lower than that of Nb. So, when the same time duration of sputtering is adopted for each sublayer, the thickness of sublayers decreases from sublayer 1 to sublayer 3 as the sputtering power of Nb decreases.

The total thickness of the corrosion-resistant layer(s) is typically greater than 50nm and is preferably greater than 100nm. The corrosion-resistant layer may have a maximum thickness of up to 3000nm, for example up to 2000nm. Accordingly, the corrosion-resistant layer(s) may have a total thickness of from 60nm to 3000nm and is preferably from 100nm to 2000nm. Here, the term total thickness refers to the thickness of all corrosion-resistant layers when there are multiple of these.

The conductivity of coated substrates depends not only on the materials present in the conductive layer, but also on the materials of the underlying layers as well as interfacial electrical resistance between the different layers. It is more meaningful to measure the electrical conductivity of the overall composite coating (together with substrate) rather than the conductivity of the conductive layer. The electrical conductivity of the coated substrates is measured via interfacial contact resistance (ICR).

Standard methods of measuring ICR of hydrogen fuel cell bipolar plates are available from U.S. Department of Energy (DOE) and are adopted here for measuring the ICR of electrolyser components such as bipolar plates. A similar method is also described in Wang H. et al., J. Power Sources, 2003, 115, 2, 243-251.

In these methods, the sample is sandwiched between two pieces of conductive carbon paper, and two copper plates are placed on the outer sides of the carbon paper while a compaction force is applied through the two copper plates. An electrical current is provided via the two copper plates and the voltage drop is measured while the compaction force is gradually increased. The total resistance (a sum of four interfacial components including two carbon paper/copper plate interfaces and two carbon paper/sample interfaces) and the interfacial contact resistance between the carbon paper/copper plate interfaces can be used to calculate the ICR of the carbon paper/sample interface.

The ICR values of coated substrates measured at 1.4MPa are typically in the range of 1-3mΩ·cm² before being subjected to the corrosion test conditions.

The overall thickness of the coating (including the seed layer, corrosion-resistant layer(s) and conductive layer) is generally 10µm or less, for example 8µm or less or 5µm or less. The overall thickness of the coating can range from 180nm to 9000nm and is preferably in the range from 600nm to 5000nm, and more preferably from 800nm to 5000nm.

The overall thickness of the coating is typically measured using a stylus profilometer. The deposition rates of different materials under different power conditions can be used to calculate the time duration required to deposit a thin layer of desired thickness. The thickness of each sublayer is typically measured, using scanning electron microscopy. This technique captures a cross-section image of the coated substrate, from which the thickness of each layer can be determined.

The seed layer, corrosion-resistant layer(s) and conductive layer may all be deposited by conventional techniques used in thin film deposition. For example, the layers may be deposited by ion implantation, sputtering, multi-arc ion plating or atomic layer deposition. Preferably, the layers are deposited by magnetron sputtering (including high-power impulse magnetron sputtering as this promotes dense coatings).

As noted above, the coatings can be used on component parts for proton exchange membrane electrolysers. Accordingly, there is also provided a coated substrate as defined herein, wherein the substrate may be a component part of a water electrolyser, e.g. a PEM electrolysis cell. The component part may be selected from an electrolyser component, bipolar plate, a current collector and a porous transport layer. The invention also provides an electrolyser comprising one or more components coated with a coating as described herein.

The invention also provides a method of making a coated substrate (e.g. a coated substrate as defined herein), the method comprising depositing onto a substrate in order:
a) a seed layer comprising Ti or oxides thereof;
b) one or more corrosion-resistant layers comprising Ti, Nb or oxides thereof, each layer comprising first, second and third , wherein the amount of Ti increases from the first to the third sublayer and the amount of Nb decreases from the first to the third sublayer;; and
c) a conductive layer comprising Nb, or nitrides and/or oxides thereof.

The substrate, seed layer, corrosion-resistant layer(s) and conductive layer may have the features and properties described above in relation to the coated substrates themselves.

The method may also comprise a pre-treatment step prior to deposition of the seed layer onto the substrate. The pre-treatment step may comprise removing any impurities (e.g. oxides or oils) from the surface of the substrate and/or etching the substrate surface. The etching may take place using an ion beam source.

The pre-treatment and/or deposition is typically conducted in a coating chamber under a vacuum environment, having a pressure of 1Pa or less, for example 0.7Pa or less, 0.5Pa or 0.3Pa or less. The pressure is maintained by argon gas. The coating chamber may be heated to a temperature above 50°C, but less than 200°C.

During the pre-treatment cleaning step, the substrate is typically biased at a voltage of between -50V and -900V and an ion cleaning time of from 0.1 hours to 1 hour may be used to remove oxides on the substrate surface.

When depositing the corrosion-resistant layer(s), metal targets may be sputtered with different powers in the presence of argon, wherein the power of the target of one of the metals gradually increases, and the power of the metal target of the other metal gradually decreases. By adjusting the power of different metal targets, the first, second and third sublayers can be deposited. As described above, the deposition of the sublayers may be repeated to form a coating with multiple corrosion-resistant layers.

### Brief Description of the Drawings

Figure 1 schematically shows the structure of a coated substrate according to one embodiment of the invention, comprising the substrate (1); a seed layer (2); a corrosion-resistant layer (3) having a first sublayer (3-1), a second sublayer (3-2), and a third sublayer (3-3); and a conductive layer (4).
Figure 2 schematically shows the structure of a coated substrate according to another embodiment of the invention, comprising the substrate (1); a seed layer (2); two corrosion-resistant layers (3), each having a first sublayer (3-1), a second sublayer (3-2), and a third sublayer (3-3); and a conductive layer (4).
Figure 3 shows the power of Ti and Nb sputtering targets against time during the deposition of a corrosion-resistant layer in a coating of the invention, wherein the ratio of the first and second transition metals varies in a step-wise manner across the sublayers.
Figure 4 shows the power of Ti and Nb sputtering targets against time during the deposition of a corrosion-resistant layer in a coating of the invention, wherein the ratio of the first and second transition metals varies gradually across the thickness of the first and third sublayers.

### Examples

The invention is now illustrated in the following examples. All of the examples below, including comparative examples, made use of TA1 titanium plate substrates. TA1 is an industrially pure titanium alloy.

### Example 1

Step 1: The pre-cleaned pure Ti substrate (TA1) was mounted onto the coating fixture (also known as the substrate holder).

Step 2: The coating fixture pre-mounted with the substrate was loaded into the coating chamber and the chamber was pumped to the desired vacuum level. The temperature of the heater was set to 135°C, and this temperature was maintained throughout the coating process.

Step 3: The chamber was vacuumed to 0.03Pa. Once the temperature reached 135°C, the pressure was maintained at 0.1Pa through the introduction of argon. A bias voltage of -700V was applied to the substrate, and ion cleaning was carried out for 0.5 hours to remove the oxide layer on the surface of the substrate.

Step 4: After the ion cleaning was completed, the vacuum was maintained, and argon and oxygen were introduced to maintain a pressure at 0.5Pa and the temperature was maintained at 135°C. The Ti and Nb metal targets were sputtered to form a dense seed layer with a thickness of 200nm on the surface of the Ti substrate.

Step 5: In the presence of argon, the Ti and Nb metal targets were sputtered with variable power sputtering, wherein the power of the Ti target gradually increased and the power of the Nb target gradually decreased (see Fig. 4). The alloy sublayer 1, the alloy sublayer 2 and the alloy sublayer 3 were deposited respectively, and the three sublayers were deposited twice (i.e., the deposition of the three layers was repeated). The thicknesses of the first, second and third alloy sublayers were 120nm, 80nm and 50nm respectively. The deposition was carried out at a pressure of 0.4Pa and a temperature of 135°C. The film thickness of the corrosion-resistant layer was 500nm.

Step 6: Finally, argon, nitrogen and oxygen were introduced to sputter the Ti and Nb targets, at a pressure of about 0.7Pa and a deposition temperature of 135°C. The thickness of the conductive layer was 500nm, in which the proportion of nitrogen atoms was 30%, and the proportion of oxygen atoms was 20%.

The overall thickness of the non-precious metal composite coating obtained was 1200nm.

The interfacial contact resistance (ICR) of the coated substrate was measured as described before. Three readings were taken under a compressive force of 1.4MPa and the average was calculated and recorded.

To enable accelerated testing, the following corrosion environment was employed: A constant potential of 2V vs. standard hydrogen electrode (SHE) for potentiostatic voltammetry; mixing 0.5M H₂SO₄ with 5ppm F⁻, which provides an acidic environment of pH 2; and a temperature of 80°C. The conditions are harsher than the actual operating conditions of a PEM electrolyser. The testing process is as follows:
1) Set up the coated substrate in a three electrode system for electrochemical testing (the coated substrate is the working electrode) and add in the electrolyte of pH 2 containing 0.5M H₂SO₄+5ppm F⁻;
2) Connect the wires of the electrochemical workstation to the three electrodes of the electrolytic system, i.e., working electrode, counter electrode, and reference electrode, respectively, and set the voltage to 2V vs. SHE;
3) Heat the electrolyte until the temperature reaches 80°C before starting potentiostatic polarization test and recording the corrosion current data;
4) Run the durability test for 10 hours.

The interfacial contact resistance (ICR) after potentiostatic polarization was tested again under a compressive force of 1.4MPa and the average of three readings was calculated and recorded.

The above testing process was adopted for all of the examples and comparative examples listed in this application.

### Test Results of Example 1

(1) Contact resistance: the initial ICR between the titanium plate and the carbon paper at 1.4MPa was 1.7 mΩ•cm², and the ICR between the substrate and the carbon paper was 6.33 mΩ•cm² after a long-term durability test (2V vs. SHE, 10 h).
(2) Potentiostatic polarization curve: In a solution of 0.5M H₂SO₄+5ppm F⁻, the corrosion current density of the potentiostatic 2V (vs. SHE) test was 3.34 µA/cm² after a long-term durability test (2V vs. SHE, 10 h).

### Comparative Example 2

Steps 1 to 3 were as described in Example 1, the only difference being that in Step 3, the bias voltage was set at -500V.

Step 4: After the ion cleaning was completed, the vacuum was maintained and a pressure of 0.5Pa was maintained with the introduction of argon. The temperature was set to 135°C, the Nb target was sputtered, and a dense seed layer of 80nm was formed on the surface of the Ti substrate.

Steps 5 and 6 were as described in Example 1.

An overall thickness of 1080nm was obtained for non-precious metal composite coating 2.

### Test Results of Comparative Example 2

(1) Contact resistance: the initial ICR between the titanium plate and the carbon paper at 1.4MPa was 1.36 mΩ•cm². The ICR between the substrate and the carbon paper was 14.28 mΩ•cm² after a long-term durability test (2V vs. SHE, 10 h).
(2) Potentiostatic polarization curve: in a solution of 0.5M H₂SO₄+5ppm F⁻, the corrosion current density of the potentiostatic 2V (vs. SHE) test was 4.74 µA/cm² after a long-term durability test (2V vs. SHE, 10 h).

### Example 3

Steps 1 to 4 were as described in Example 1.

Step 5: Argon gas was introduced and the metal targets of Ti, Zr, Nb, and W were sputtered with variable power, in which the power of the Ti and Zr targets was gradually increased, and the power of the Nb and W targets was gradually decreased. The alloy sublayer 1, alloy sublayer 2 and alloy sublayer 3 were deposited respectively, and the three sublayers were deposited twice (repeating the variable power cycle), wherein the thicknesses of the alloy sublayers were 200nm, 120nm, 80nm, the deposition pressure was 0.4Pa, and the deposition temperature was 135 °C, forming a dense corrosion-resistant layer with a thickness of 800nm.

Step 6 was as described in Example 1.

An overall thickness of 1500nm was obtained for non-precious metal composite coating 3.

### Test Results of Example 3

(1) Contact resistance: the initial ICR between the titanium plate and the carbon paper at 1.4MPa was 1.76 mΩ•cm². The ICR between the substrate and the carbon paper was 15.34 mΩ•cm² after a long-term durability test (2V vs. SHE, 10 h).
(2) Potentiostatic polarization curve: in a solution of 0.5M H₂SO₄+5ppm F⁻, the corrosion current density of the potentiostatic 2V (vs. SHE) test was 4.66 µA/cm² after a long-term durability test (2V vs. SHE, 10 h).

### Comparative Example 4

Steps 1 to 3 were as described in Example 1.

Step 4: After the ion cleaning was completed, the chamber was vacuumed to the deposition pressure and argon and oxygen were introduced to maintain the pressure at 0.5Pa. The temperature was maintained at 135°C, the Nb target was sputtered, and a dense seed layer was formed on the surface of the Ti substrate with a thickness of 20nm.

Step 5: Argon gas was introduced and Ti and Nb metal targets were sputtered with variable power sputtering, wherein the power of Ti target was gradually increased, while the power of Nb target was gradually decreased. The alloy sublayer 1, alloy sublayer 2 and alloy sublayer 3 were deposited respectively, and the three sublayers were deposited twice, wherein the thicknesses of the alloy sublayers were 24nm, 16nm, 10nm, respectively. The deposition pressure was 0.4Pa, the deposition temperature was 135 °C, and a dense corrosion-resistant layer with a thickness of 100nm was formed.

Step 6: Finally, argon and nitrogen were used to sputter the Ti target at a deposition pressure of approximately 0.7Pa and a deposition temperature of 135°C. A conductive layer was formed with a thickness of 100nm.

An overall thickness of 220nm was obtained for non-precious metal composite coating 4.

### Test Results of Comparative Example 4

(1) Contact resistance: the initial ICR between the titanium plate and the carbon paper at 1.4MPa was 1.05 mΩ•cm². The ICR between the substrate and the carbon paper was 794.15 mΩ•cm² after a long-term durability test (2V vs. SHE, 10 h).
(2) Potentiostatic polarization curve: in a solution of 0.5M H₂SO₄+5ppm F⁻, the corrosion current density of the potentiostatic 2V (vs. SHE) test was 1.53 µA/cm2 after a long-term durability test (2V vs. SHE, 10 h).

### Example 5

Steps 1 to 3 were as described in Example 1.

Step 4: After the ion cleaning was finished, the chamber was vacuumed to the deposition pressure, argon gas was introduced at a pressure of 0.5Pa, the temperature was maintained at 135°C, the Ti and Nb metal targets were sputtered, and a dense seed layer was formed on the surface of the Ti substrate with a thickness of 200nm.

Steps 5 and 6 were as described in Example 1.

An overall thickness of 1200nm was obtained for non-precious metal composite coating 5.

### Test Results of Example 5

(1) Contact resistance: the initial ICR between the titanium plate and the carbon paper at 1.4MPa was 1.45 mΩ•cm². The ICR between the substrate and the carbon paper was 15.29 mΩ•cm² after a long-term durability test (2V vs. SHE, 10 h).
(2) Potentiostatic polarization curve: in a solution of 0.5M H₂SO₄+5ppm F⁻, the corrosion current density of the potentiostatic 2V (vs. SHE) test was 4.13 µA/cm² after a long-term durability test (2V vs. SHE, 10 h).

### Example 6

Steps 1 to 5 were as described in Example 1.

Step 6: Argon, nitrogen and oxygen were introduced to sputter the Ti, Nb, Zr, W targets. The deposition pressure was approximately 0.7Pa, the deposition temperature was 135 °C, and the thickness of the conductive layer was 500 nm, in which the proportion of nitrogen atoms was 20% and the proportion of oxygen atoms was 5%.

An overall thickness of 1200nm was obtained for non-precious metal composite coating 6.

### Test Results of Example 6

(1) Contact resistance: the initial ICR between the titanium plate and the carbon paper at 1.4MPa was 1.6 mΩ•cm². The ICR between the substrate and the carbon paper was 10.31 mΩ•cm² after a long-term durability test (2V vs. SHE, 10 h).
(2) Potentiostatic polarization curve: in a solution of 0.5M H₂SO₄+5ppm F⁻, the corrosion current density of the potentiostatic 2V (vs. SHE) test was 4.52 µA/cm² after a long-term durability test (2V vs. SHE, 10 h).

### Example 7

Steps 1 to 3 were as described in Example 1.

Step 4: After ion cleaning, the chamber was vacuumed to the deposition pressure, argon and oxygen were introduced to maintain the pressure at 0.5Pa, the temperature was maintained at 135 °C, the Ti and Nb targets were sputtered, and a dense seed layer was formed on the surface of the Ti substrate with a thickness of 250nm.

Step 5: Argon and nitrogen were introduced, and the Ti and Nb metal targets were sputtered with variable power sputtering, wherein the power of the Ti target was gradually increased, and the power of the Nb target was gradually decreased. The alloy sublayer 1, alloy sublayer 2 and alloy sublayer 3 were deposited respectively, the three sublayers were deposited twice, wherein the thicknesses of the alloy sublayers were 100nm, 60nm, 40nm, respectively. The deposition pressure was 0.7Pa, the deposition temperature was 135°C and a corrosion-resistant layer was formed with a thickness of 400nm.

Step 6 was as described in Example 1.

An overall thickness of 1150nm was obtained for non-precious metal composite coating 7.

### Test Results of Example 7

(1) Contact resistance: the initial ICR between the titanium plate and the carbon paper at 1.4MPa was 2.15 mΩ•cm². The ICR between the substrate and the carbon paper was 65.14 mΩ•cm², after a long-term durability test (2V vs. SHE, 10 h).
(2) Potentiostatic polarization curve: in a solution of 0.5M H₂SO₄+5ppm F⁻, the corrosion current density of the potentiostatic 2V (vs. SHE) test was 2.96 µA/cm² after a long-term durability test (2V vs. SHE, 10 h).

### Example 8

Steps 1 to 3 were as described in Example 1.

Step 4: After the ion cleaning was completed, the chamber was vacuumed to the deposition pressure, argon and oxygen were introduced to maintain the pressure at 0.5Pa, the temperature was maintained at 135 °C, the Ti and Nb metal targets were sputtered, and a dense seed layer was formed on the surface of the Ti substrate with a thickness of 250nm.

Step 5: Argon gas and acetylene gas were introduced, and the Ti and Nb metal targets were sputtered 3 times using variable power sputtering, wherein the power of the Ti target was gradually increased, and the power of the Nb target was gradually decreased. The alloy sublayer 1, alloy sublayer 2 and alloy sublayer 3 were deposited respectively, and the three sublayers were deposited twice, wherein the thicknesses of the alloy sublayers were 160nm, 110nm, 55nm, respectively. The deposition pressure was 0.5Pa, the deposition temperature was 135°C. A corrosion-resistant layer was formed with a thickness of 650nm.

Step 6 was the same as described in Example 1.

An overall thickness of 1400 nm was obtained for non-precious metal composite coating 8.

### Test Results of Example 8

(1) Contact resistance: the initial ICR between the titanium plate and the carbon paper at 1.4MPa was 1.36 mΩ•cm². The ICR between the substrate and the carbon paper was 20.05 mΩ•cm² after a long-term durability test (2V vs. SHE, 10 h).
(2) Potentiostatic polarization curve: in a solution of 0.5M H₂SO₄+5ppm F⁻, the corrosion current density of the potentiostatic 2V (vs. SHE) test was 5.32 µA/cm² after a long-term durability test (2V vs. SHE, 10 h).

### Example 9

Steps 1 to 3 were as described in Example 1.

Step 4: After the ion cleaning was completed, the chamber was vacuumed to the deposition pressure, argon gas was introduced and the chamber pressure was maintained at 0.5Pa, the temperature was maintained at 135°C, the Ti metal target was sputtered, and a dense seed layer of Ti with a thickness of 200nm was formed on the surface of the Ti substrate.

Steps 5 and 6 were as described in Example 1.

An overall thickness of 1200 nm was obtained for non-precious metal composite coating 9.

### Test Results of Example 9

(1) Contact resistance: the initial ICR between the titanium plate and the carbon paper at 1.4MPa was 1.4 mΩ•cm². The ICR between the substrate and the carbon paper was 9.2 mΩ•cm² after a long-term durability test (2V vs. SHE, 10 h).
(2) Potentiostatic polarization curve: in a solution of 0.5M H₂SO₄+5ppm F⁻, the corrosion current density of the potentiostatic 2V (vs. SHE) test was 3.65 µA/cm² after a long-term durability test (2V vs. SHE, 10 h).

### Example 10

Steps 1 to 4 were as described in Example 1.

Step 5: Argon gas was introduced, Ti and Nb metal targets were sputtered 3 times using variable power sputtering, wherein the power of the Ti target gradually increased and the power of the Nb target gradually decreased (see Fig. 4). The alloy sublayer 1, the alloy sublayer 2 and the alloy sublayer 3 were deposited, respectively, and the three sublayers were repeatedly deposited four times, wherein the thicknesses of the alloy sublayers were 120nm, 80nm, 50nm, respectively. The deposition pressure was 0.4Pa, the deposition temperature was 135°C, and the film thickness of the corrosion-resistant layer was 1000nm.

Step 6 was as described in Example 1.

An overall thickness of 1700nm non-precious metal composite coating 10 was obtained.

### Test Results of Example 10

(1) Contact resistance: the initial ICR between the titanium plate and the carbon paper at 1.4MPa was 2 mΩ•cm^{2.} The ICR between the substrate and the carbon paper was 20.1 mΩ•cm² after a long-term durability test (2V vs. SHE, 10 h).
(2) Potentiostatic polarization curve: in the solution of 0.5M H₂SO₄+5ppm F⁻, the corrosion current density of the potentiostatic 2V (vs. SHE) test was 4.14 µA/cm² after a long-term durability test (2V vs. SHE, 10 h).

### Example 11

Steps 1 to 3 were as described in Example 1.

Step 4: After the ion cleaning was completed, the chamber was vacuumed to the deposition pressure, argon and oxygen were introduced to maintain the pressure at 0.5Pa, the temperature was maintained at 135°C, the Ti and Nb metal targets were sputtered, and a dense seed layer with a thickness of 100nm was formed on the surface of the Ti substrate.

Step 5: Argon gas was introduced, Ti and Nb metal targets were sputtered 3 times using variable power sputtering, wherein the power of the Ti target gradually increased and the power of the Nb target gradually decreased (see Fig. 4). The alloy sublayer 1, the alloy sublayer 2 and the alloy sublayer 3 were deposited respectively, and the three sublayers were deposited two times, wherein the thicknesses of the alloy sublayers were 60nm, 40nm, 25nm, respectively. The deposition pressure was 0.4Pa, the deposition temperature was 135°C, and the film thickness of the corrosion-resistant layer was 250nm.

Step 6: Argon, nitrogen and oxygen were introduced to sputter the Ti and Nb targets. The deposition pressure was approximately 0.7Pa, the deposition temperature was 135 °C, and the thickness of the conductive layer was 250nm, in which the proportion of nitrogen atoms was 30%, the proportion of oxygen atoms was 20%.

An overall thickness of 600nm non-precious metal composite coating 11 was obtained.

### Test Results of Example 11

(1) Contact resistance: the initial ICR between the titanium plate and the carbon paper at 1.4MPa was 3.95 mΩ•cm². The ICR between the substrate and the carbon paper was 384.5 mΩ•cm² after a long-term durability test (2V vs. SHE, 10 h).
(2) Potentiostatic polarization curve: in the solution of 0.5M H₂SO₄+5ppm F⁻, the corrosion current density of the potentiostatic 2V (vs. SHE) test was 2.09 µA/cm² after a long-term durability test (2V vs. SHE, 10 h).

### Example 12

Steps 1 to 3 were as described in Example 1.

Step 4: After the ion cleaning was completed, the chamber was vacuumed to the deposition pressure, argon and oxygen were introduced to maintain the pressure at 0.5Pa, the temperature was maintained at 135°C, the Ti and Nb metal targets were sputtered, and a dense seed layer with a thickness of 130nm was formed on the surface of the Ti substrate.

Step 5: Argon gas was introduced, Ti and Nb metal targets were sputtered using variable power sputtering, wherein the power of the Ti target gradually increased and the power of the Nb target gradually decreased (see Fig. 4). The alloy sublayer 1, the alloy sublayer 2 and the alloy sublayer 3 were deposited respectively, and the three sublayers were deposited two times, wherein the thicknesses of the alloy sublayers were 80nm, 50nm, 40nm, respectively. The deposition pressure was 0.4Pa, the deposition temperature was 135°C, and the film thickness of the corrosion-resistant layer was 340nm.

Step 6: Argon, nitrogen and oxygen were introduced to sputter the Ti and Nb targets. The deposition pressure was about 0.7Pa, the deposition temperature was 135 °C, and the thickness of the conductive layer was 330nm, in which the proportion of nitrogen atoms was 25%, the proportion of oxygen atoms was 20%.

An overall thickness of 800nm non-precious metal composite coating 12 was obtained.

### Test Results of Example 12

(1) Contact resistance: the initial ICR between the titanium plate and the carbon paper at 1.4MPa was 1.25 mΩ•cm². The ICR between the substrate and the carbon paper was 52.75 mΩ•cm² after a long-term durability test (2V vs. SHE, 10 h).
(2) Potentiostatic polarization curve: in the solution of 0.5M H₂SO₄+5ppm F⁻, the corrosion current density of the potentiostatic 2V (vs. SHE) test was 3.47 µA/cm² after a long-term durability test (2V vs. SHE, 10 h).

### Example 13

Steps 1 to 4 were as described in Example 1.

Step 5: Argon gas was introduced, Ti and Nb metal targets were sputtered 3 times using variable power sputtering, wherein the power of the Ti target gradually increased and the power of the Nb target gradually decreased (see Fig. 4). The alloy sublayer 1, the alloy sublayer 2 and the alloy sublayer 3 were deposited respectively, and the three sublayers were repeatedly deposited six times, wherein the thicknesses of the alloy sublayers were 120nm, 80nm, 50nm, respectively. The deposition pressure was 0.4Pa, the deposition temperature was 135°C, and the film thickness of the corrosion-resistant layer was 1500nm.

Step 6 was the same as described in Example 1.

An overall thickness of 2200nm non-precious metal composite coating 13 was obtained.

### Test Results of Example 13

(1) Contact resistance: the initial ICR between the titanium plate and the carbon paper at 1.4MPa was 1.95mΩ•cm². The ICR between the substrate and the carbon paper was 4.12mΩ•cm² after a long-term durability test (2V vs. SHE, 10 h).
(2) Potentiostatic polarization curve: in the solution of 0.5M H₂SO₄+5ppm F⁻, the corrosion current density of the potentiostatic 2V (vs. SHE) test was 4.29µA/cm² after a long-term durability test (2V vs. SHE, 10 h).

### Example 14

Steps 1 to 3 were as described in Example 1.

Step 4: After the ion cleaning was completed, the chamber was vacuumed to the deposition pressure, argon and oxygen were introduced to maintain the pressure at 0.5Pa, the temperature was maintained at 135°C, the Ti and Nb metal targets were sputtered, and a dense seed layer with a thickness of 500nm was formed on the surface of the Ti substrate.

Step 5: Argon gas was introduced, Ti and Nb metal targets were sputtered 3 times using variable power sputtering, wherein the power of the Ti target gradually increased and the power of the Nb target gradually decreased (see Fig. 4).. The alloy sublayer 1, the alloy sublayer 2 and the alloy sublayer 3 were deposited respectively, and the three sublayers were deposited two times, wherein the thicknesses of the alloy sublayers were 240nm, 160nm, 100nm, respectively. The deposition pressure was 0.4Pa, the deposition temperature was 135°C, and the film thickness of the corrosion-resistant layer was 1000nm.

Step 6: Argon, nitrogen and oxygen were introduced to sputter the Ti and Nb targets. The deposition pressure was approximately 0.7Pa, the deposition temperature was 135 °C, and the thickness of the conductive layer was 1500nm, in which the proportion of nitrogen atoms was 30%, the proportion of oxygen atoms was 20%.

The overall thickness of 3000nm non-precious metal composite coating 14 was obtained.

### Test Results of Example 14

(1) Contact resistance: the initial ICR between the titanium plate and the carbon paper at 1.4MPa was 2.72 mΩ•cm². The ICR between the substrate and the carbon paper was 15.78 mΩ•cm² after a long-term durability test (2V vs. SHE, 10 h).
(2) Potentiostatic polarization curve: in the solution of 0.5M H₂SO₄+5ppm F⁻, the corrosion current density of the potentiostatic 2V (vs. SHE) test was 4.59 µA/cm² after a long-term durability test (2V vs. SHE, 10 h).

### Example 15

Steps 1 to 3 were as described in Example 1.

Step 4: After the ion cleaning was completed, the chamber was vacuumed to the deposition pressure, argon and oxygen were introduced to maintain the pressure at 0.5Pa, the temperature was maintained at 135°C, the Ti and Nb metal targets were sputtered, and a dense seed layer with a thickness of 800nm was formed on the surface of the Ti substrate.

Step 5: Argon gas was introduced, Ti and Nb metal targets were sputtered 3 times using variable power sputtering, wherein the power of the Ti target gradually increased and the power of the Nb target gradually decreased (see Fig. 4). The alloy sublayer 1, the alloy sublayer 2 and the alloy sublayer 3 were deposited respectively, and the three sublayers were deposited two times, wherein the thicknesses of the alloy sublayers were 480nm, 320nm, 200nm, respectively. The deposition pressure was 0.4Pa, the deposition temperature was 135°C, and the film thickness of the corrosion-resistant layer was 2000nm.

Step 6: Argon, nitrogen and oxygen were introduced to sputter the Ti and Nb targets. The deposition pressure was about 0.7Pa, the deposition temperature was 135 °C, and the thickness of the conductive layer was 2000nm, in which the proportion of nitrogen atoms was 30%, the proportion of oxygen atoms was 20%.

An overall thickness of 4800nm non-precious metal composite coating 15 was obtained.

### Test Results Example 15

(1) Contact resistance: the initial ICR between the titanium plate and the carbon paper at 1.4MPa was 1.7mΩ•cm². The ICR between the substrate and the carbon paper was 7.73mΩ•cm² after a long-term durability test (2V vs. SHE, 10 h).
(2) Potentiostatic polarization curve: in the solution of 0.5M H₂SO₄+5ppm F⁻, the corrosion current density of the potentiostatic 2V (vs. SHE) test was 11.2µA/cm² after a long-term durability test (2V vs. SHE, 10 h).

### Example 16

Steps 1 to 4 were as described in Example 1.

Step 5: In the presence of argon, the Ti and Nb metal targets were sputtered with step-wise variable power sputtering as shown in Figure 3, wherein the power of the Ti target was constant and low in sublayer 1, medium in sublayer 2, and high in sublayer 3. The power of the Nb target was constant at each sublayer and decreased in a step-wise fashion from sublayer 1 to sublayer 3. The three sublayers were deposited wherein the thicknesses of the alloy sublayers were 240nm, 160nm, 100nm, the deposition pressure was 0.4Pa, the deposition temperature was 135°C, and the film thickness of the corrosion-resistant layer was 500nm.

Step 6 was as described in Example 1.

An overall thickness of 1200nm non-precious metal composite coating 16 was obtained.

### Test Results of Example 16

(1) Contact resistance: the initial ICR between the titanium plate and the carbon paper at 1.4MPa was 1.3mΩ•cm². The ICR between the substrate and the carbon paper was 9.2mΩ•cm2 after a long-term durability test (2V vs. SHE, 10 h).
(2) Potentiostatic polarization curve: in the solution of 0.5M H₂SO₄+5ppm F⁻, the corrosion current density of the potentiostatic 2V (vs. SHE) test was 2.71µA/cm² after a long-term durability test (2V vs. SHE, 10 h).

### Example 17

Steps 1 to 4 were as described in Example 1.

Step 5: In the presence of argon, the Ti and Nb metal targets were sputtered with step-wise variable power sputtering, wherein the power of the Ti target was constant and low in sublayer 1, medium in sublayer 2, and high in sublayer 3. The power of the Nb target was constant at each sublayer and decreased in a step-wise fashion from sublayer 1 to sublayer 3. The first three sublayers were deposited wherein the thicknesses of the alloy sublayers were 120nm, 80nm, 50nm, and the three sublayers were repeated to produce another set of three sublayers. The deposition pressure was 0.4Pa, the deposition temperature was 135°C, and the film thickness of the corrosion-resistant layer was 500nm.

Step 6 was as described in Example 1.

An overall thickness of 1200nm non-precious metal composite coating 17 was obtained.

### Example 17 test results

(1) Contact resistance: the initial ICR between the titanium plate and the carbon paper at 1.4MPa was 1.75mΩ•cm². The ICR between the substrate and the carbon paper was 9.3mΩ•cm² after a long-term durability test (2V vs. SHE, 10 h);
(2) Potentiostatic polarization curve: in the solution of 0.5M H₂SO₄+5ppm F⁻, the corrosion current density of the potentiostatic 2V (vs. SHE) test was 3.01µA/cm² after a long-term durability test (2V vs. SHE, 10 h);

### Comparative Example 1: Ti plate without coating

(1) Contact resistance: the initial contact resistance between the titanium plate and the carbon paper at 1.4MPa was 16.4 mΩ•cm². The contact resistance between the substrate and the carbon paper was 1197.8 mΩ•cm² after a long-term durability test (2V vs. SHE, 10 h);
(2) Potentiostatic polarization curve: in the solution of 0.5M H₂SO₄+5ppm F⁻, the corrosion current density of the potentiostatic 2V (vs. SHE) test was 4.42 µA/cm² after a long-term durability test (2V vs. SHE, 10 h).

### Comparative Example 2A: Ti plate with 500nm platinum coating

(1) Contact resistance: the initial ICR between the titanium plate and the carbon paper at 1.4MPa was 1.25 mΩ•cm². The ICR between the substrate and the carbon paper was 3.85 mΩ•cm² after a long-term durability test (2V vs. SHE, 10 h);
(2) Potentiostatic polarization curve: in the solution of 0.5M H₂SO₄+5ppm F⁻, the corrosion current density of the potentiostatic 2V (vs. SHE) test was 533 µA/cm² after a long-term durability test (2V vs. SHE, 10 h).

### Comparative Example 3

Steps 1 to 3 were as described in Example 1.

Step 4: After the ion cleaning was completed, the chamber was vacuumed to the deposition pressure, the pressure of argon gas was maintained at 0.5Pa, the temperature was maintained at 135°C, the Ti metal target was sputtered, and a dense seed layer of Ti with a thickness of 200nm was formed on the surface of the Ti substrate.

Step 5: Argon gas was introduced, the Ti and Nb metal targets were sputtered with constant power, the deposition pressure was 0.4Pa, the deposition temperature was 135°C, and the thickness of the alloy layer was 500nm.

Step 6 was as described in Example 1.

The overall thickness of comparative example coating 3 was 1200nm.

### Test Results of Comparative Example 3

(1) Contact resistance: the initial ICR between the titanium plate and the carbon paper at 1.4MPa was 3.98 mΩ•cm². The ICR between the substrate and the carbon paper was 320.82 mΩ•cm² after a long-term durability test (2V vs. SHE, 10 h).
(2) Potentiostatic polarization curve: in the solution of 0.5M H₂SO₄+5ppm F⁻, the corrosion current density of the potentiostatic 2V (vs. SHE) test was 3.67 µA/cm² after a long-term durability test (2V vs. SHE, 10 h).

### Comparative Example 4A

Steps 1 to 3 were as described in Example 1.

Step 4: After the ion cleaning was completed, the chamber was vacuumed to the deposition pressure, argon and oxygen was introduced to maintain the pressure at 0.5Pa, the temperature was maintained at 135°C, the Ti metal target was sputtered, and a dense seed layer with a thickness of 200nm was formed on the surface of the Ti substrate.

Step 5: Argon gas was introduced, the Ti and Nb metal targets were sputtered with constant power, the deposition pressure was 0.4Pa, the deposition temperature was 135°C, and the thickness of the alloy layer was 500nm.

Step 6 was as described in Example 1.

The overall thickness of comparative example coating 4 was 1200nm.

### Test Results of Comparative Example 4A

(1) Contact resistance: the initial ICR between the titanium plate and the carbon paper at 1.4MPa was 2.8mΩ•cm². The ICR between the substrate and the carbon paper was 70.13mΩ•cm² after a long-term durability test (2V vs. SHE, 10 h);
(2) Potentiostatic polarization curve: in the solution of 0.5M H₂SO₄+5ppm F⁻, the corrosion current density of the potentiostatic 2V (vs. SHE) test was 3.9µA/cm² after a long-term durability test (2V vs. SHE, 10 h).

### Comparative Example 5

(1) Contact resistance: the initial contact resistance between a titanium plate coated with a 400nm single layer Ti coating and the carbon paper at 1.4MPa was 8.53 mΩ•cm². The contact resistance between the titanium plate coated with a single layer Ti coating and the carbon paper was 153.37 mΩ•cm² after a long-term durability test carried out in a pH 2 solution (2V vs. SHE, 80 °C, 3 h);
(2) Potentiostatic polarization curve: in the solution of 0.5M H₂SO₄+5ppm F⁻, the corrosion current density of the potentiostatic 2V (vs. SHE) test was 3.67 µA/cm² after a long-term durability test (2V vs. SHE, 80 °C, 3 h).

### Comparative Example 6

(1) Contact resistance: the initial contact resistance between a titanium plate coated with a 400nm single layer Nb coating and the carbon paper at 1.4MPa was 1.78 mΩ•cm². The contact resistance between the titanium plate coated with a single layer Nb coating and the carbon paper was 100.44 mΩ•cm² after a long-term durability test carried out in a pH 2 solution (2V vs. SHE, 80 °C, 3 h);
(2) Potentiostatic polarization curve: in the solution of 0.5M H₂SO₄+5ppm F⁻, the corrosion current density of the potentiostatic 2V (vs. SHE) test was 9.54 µA/cm² after a long-term durability test (2V vs. SHE, 80 °C, 3 h).

The test results of the examples are as follows:

| **Examples** | **Coating Thickness(nm)** | **ICR before polarization @1.4MPa (mΩ•cm²)** | **ICR after polarization @1.4MPa (mΩ•cm²)** | **Corrosion current density (µA/cm²)** |
|---|---|---|---|---|
| Example 1 | 1200 | 1.7 | 6.33 | 3.34 |
| Comparative Example 2 | 1080 | 1.36 | 14.28 | 4.74 |
| Example 3 | 1500 | 1.76 | 15.34 | 4.66 |
| Comparative Example 4 | 220 | 1.05 | 794.15 | 1.53 |
| Example 5 | 1200 | 1.45 | 15.29 | 4.13 |
| Example 6 | 1200 | 1.6 | 10.31 | 4.52 |
| Example 7 | 1150 | 2.15 | 65.14 | 2.96 |
| Example 8 | 1400 | 1.36 | 20.05 | 5.32 |
| Example 9 | 1200 | 1.4 | 9.2 | 3.65 |
| Example 10 | 1700 | 2 | 20.1 | 4.14 |
| Example 11 | 600 | 3.95 | 384.5 | 2.09 |
| Example 12 | 800 | 1.25 | 52.75 | 3.47 |
| Example 13 | 2200 | 1.95 | 4.12 | 4.29 |
| Example 14 | 3000 | 2.72 | 15.78 | 4.59 |
| Example 15 | 4800 | 1.7 | 7.73 | 11.2 |
| Example 16 | 1200 | 1.3 | 9.2 | 2.71 |
| Example 17 | 1200 | 1.75 | 9.3 | 3.01 |
| Comparative Example 1 | - | 16.4 | 1197.8 | 4.42 |
| Comparative Example 2A | 500 | 1.25 | 3.85 | 533 |
| Comparative Example 3 | 1200 | 3.98 | 320.82 | 3.67 |
| Comparative Example 4A | 1200 | 2.8 | 70.13 | 3.9 |
| Comparative Example 5 | 400 | 8.53 | 153.37 | 3.67 |
| Comparative Example 6 | 400 | 1.78 | 100.44 | 9.54 |

From the above table, it can be seen that the initial interfacial contact resistance (ICR) of the currently developed composite coating was mostly less than 2 mΩ•cm² at 1.4MPa, which is comparable to the conductivity of the Comparative Example 2A platinum coating, but the corrosion current density is much smaller than that of the platinum coating, indicating that the corrosion resistance of the composite coating is better.

The ICR values have generally increased after the 10-hour corrosion durability test. It can be seen that with the composite coatings of the present invention, the ICR values after polarization are markedly lower than that of Ti plates without any coating (Comparative Example 1).

Comparative Examples 3 and 4A have a monolayer alloy structure as the middle layer, and when compared to composite coatings of the same overall thickness with multiple middle sublayers deposited with power changes (see Examples 1, 5, 6, 9), the initial and post-polarization ICR values of Examples 1, 5, 6, and 9 are lower, demonstrating the advantages of having multiple alternating sublayers as the middle layer.

The difference between Comparative Example 3 and Comparative Example 4A is in the seed layer, which in Comparative Example 3 is Ti and in Comparative Example 4A contains both Ti and O. Comparative Example 4A has lower contact resistance both before and after the polarisation test, indicating that the presence of oxygen in the seed layer improves the overall performance of the composite coatings. The same trend can also be observed in Example 1 and Example 5, where the presence of oxygen in the seed layer contributes to lower ICR after corrosion durability test, improving the electrical conductivity of the coated components under operational conditions.

In summary, the coatings of the present invention use non-precious metal materials and have great advantages in performance and cost and can play an important role in promoting the use of water electrolysers.

Comparative Examples 5 and 6 demonstrate that single-layer Ti coated substrates exhibit lower corrosion current density and hence better corrosion resistance compared to single-layer Nb coated substrates. The initial and post-polarization ICR values of single-layer Nb coated substrates (comparative example 6) are lower than those of single-layer Ti coated substrates (comparative Example 5), due to the increased electrical conductivity of Nb relative to Ti.

## Claims

1. A coated substrate comprising in order:
a) a substrate;
b) a seed layer comprising Ti or oxides thereof;
c) one or more corrosion-resistant layers comprising Ti, Nb or oxides thereof, each layer comprising first, second and third sublayers wherein the amount of Ti increases from the first to the third sublayer and the amount of Nb decreases from the first to the third sublayer, and
d) a conductive layer comprising Nb, or nitrides and/or oxides thereof.

2. A coated substrate according to claim 1 wherein the ratio of Ti and Nb in each sublayer of the one or more corrosion-resistant layers is constant across its thickness.

3. A coated substrate according to claim 1 wherein the ratio of Ti and Nb in at least the first and third sublayers of the one or more corrosion-resistant layers varies across its thickness.

4. A coated substrate according to any one of claims 1 to 3 wherein the substrate is a titanium substrate.

5. A coated substrate according to any one of claims 1 to 4 wherein the seed layer further comprises Nb or oxides thereof.

6. A coated substrate according to any one of claims 1 to 5 wherein the seed layer has a thickness of from 20nm to 1000nm.

7. A coated substrate according to any one of claims 1 to 6 wherein each sublayer in the corrosion-resistant layer has a thickness of from 20nm to 500nm.

8. A coated substrate according to any one of claims 1 to 7 comprising two or more corrosion-resistant layers, each layer comprising first, second and third sublayers as defined in any one of claims 1 to 7.

9. A coated substrate according to any one of claims 1 to 8 wherein the conductive layer further comprises Ti or oxides, oxynitrides and/or nitrides thereof.

10. A coated substrate according to any one of claims 1 to 9 wherein the overall thickness of the seed layer, one or more corrosion-resistant layers and the conductive layer is from 180nm to 9000nm.

11. A coated substrate according to any one of claims 1 to 10 wherein the substrate is selected from an electrolyser component, bipolar plate, current collector and porous transport layer.

12. A method of making a coated substrate according to any one of claims 1 to 11, the method comprising depositing onto the substrate in order:
a) a seed layer comprising Ti or oxides thereof;
b) one or more corrosion-resistant layers comprising Ti, Nb or oxides thereof, each layer comprising first, second and third sublayers, wherein the amount of Ti increases from the first to the third sublayer and the amount of Nb decreases from the first to the third sublayer; and
c) a conductive layer comprising Nb, or nitrides and/or oxides thereof.

13. An electrolyser comprising a coated substrate according to any one of claims 1 to 11.

## Patentansprüche

1. Beschichtetes Substrat, der Reihe nach Folgendes umfassend:
a) ein Substrat;
b) eine Keimschicht, die Ti oder Oxide davon umfasst;
c) eine oder mehrere korrosionsbeständige Schichten, die Ti, Nb oder Oxide davon umfassen, wobei jede Schicht eine erste, eine zweite und eine dritte Teilschicht umfasst, wobei die Menge an Ti von der ersten zu der dritten Teilschicht zunimmt und die Menge an Nb von der ersten zu der dritten Teilschicht abnimmt, und
d) eine leitfähige Schicht, die Nb oder Nitride und/oder Oxide davon umfasst.

2. Beschichtetes Substrat nach Anspruch 1, wobei das Verhältnis von Ti und Nb in jeder Teilschicht der einen oder mehreren korrosionsbeständigen Schichten über ihre Dicke konstant ist.

3. Beschichtetes Substrat nach Anspruch 1, wobei das Verhältnis von Ti und Nb in mindestens der ersten und der dritten Teilschicht der einen oder mehreren korrosionsbeständigen Schichten über ihre Dicke variiert.

4. Beschichtetes Substrat nach einem der Ansprüche 1 bis 3, wobei das Substrat ein Titansubstrat ist.

5. Beschichtetes Substrat nach einem der Ansprüche 1 bis 4, wobei die Keimschicht ferner Nb oder Oxide davon umfasst.

6. Beschichtetes Substrat nach einem der Ansprüche 1 bis 5, wobei die Keimschicht eine Dicke von 20 nm bis 1000 nm aufweist.

7. Beschichtetes Substrat nach einem der Ansprüche 1 bis 6, wobei jede Teilschicht in der korrosionsbeständigen Schicht eine Dicke von 20 nm bis 500 nm aufweist.

8. Beschichtetes Substrat nach einem der Ansprüche 1 bis 7, umfassend zwei oder mehr korrosionsbeständige Schichten, wobei jede Schicht eine erste, eine zweite und eine dritte Teilschicht, wie in einem der Ansprüche 1 bis 7 definiert, umfasst.

9. Beschichtetes Substrat nach einem der Ansprüche 1 bis 8, wobei die leitfähige Schicht ferner Ti oder Oxide, Oxynitride und/oder Nitride davon umfasst.

10. Beschichtetes Substrat nach einem der Ansprüche 1 bis 9, wobei die Gesamtdicke der Keimschicht, der einen oder mehreren korrosionsbeständigen Schichten und der leitfähigen Schicht 180 nm bis 9000 nm beträgt.

11. Beschichtetes Substrat nach einem der Ansprüche 1 bis 10, wobei das Substrat aus einer Elektrolyseur-Komponente, einer bipolaren Platte, einem Stromsammler und einer porösen Transportschicht ausgewählt ist.

12. Verfahren zum Herstellen eines beschichteten Substrats nach einem der Ansprüche 1 bis 11, wobei das Verfahren Abscheiden des Folgenden der Reihe nach auf das Substrat umfasst:
a) eine Keimschicht, die Ti oder Oxide davon umfasst;
b) eine oder mehrere korrosionsbeständige Schichten, die Ti, Nb oder Oxide davon umfassen, wobei jede Schicht eine erste, eine zweite und eine dritte Teilschicht umfasst, wobei die Menge an Ti von der ersten zu der dritten Teilschicht zunimmt und die Menge an Nb von der ersten zu der dritten Teilschicht abnimmt; und
c) eine leitfähige Schicht, die Nb oder Nitride und/oder Oxide davon umfasst.

13. Elektrolyseur, umfassend ein beschichtetes Substrat nach einem der Ansprüche 1 bis 11.

## Revendications

1. Substrat revêtu comprenant dans l'ordre :
a) un substrat ;
b) une couche germe comprenant du Ti ou des oxydes de celui-ci ;
c) une ou plusieurs couches résistantes à la corrosion comprenant du Ti, du Nb ou des oxydes de ceux-ci, chaque couche comprenant de première, deuxième et troisième sous-couches dans lequel la quantité de Ti augmente de la première à la troisième sous-couche et la quantité de Nb diminue de la première à la troisième sous-couche, et
d) une couche conductrice comprenant du Nb, ou des nitrures et/ou des oxydes de celui-ci.

2. Substrat revêtu selon la revendication 1 dans lequel le rapport de Ti et Nb dans chaque sous-couche des une ou plusieurs couches résistantes à la corrosion est constant sur toute son épaisseur.

3. Substrat revêtu selon la revendication 1 dans lequel le rapport de Ti et Nb dans au moins la première et la troisième sous-couches des une ou plusieurs couches résistantes à la corrosion varie à travers son épaisseur.

4. Substrat revêtu selon l'une quelconque des revendications 1 à 3 dans lequel le substrat est un substrat en titane.

5. Substrat revêtu selon l'une quelconque des revendications 1 à 4 dans lequel la couche germe comprend en outre du Nb ou des oxydes de celui-ci.

6. Substrat revêtu selon l'une quelconque des revendications 1 à 5 dans lequel la couche germe présente une épaisseur de 20 nm à 1 000 nm.

7. Substrat revêtu selon l'une quelconque des revendications 1 à 6 dans lequel chaque sous-couche dans la couche résistante à la corrosion présente une épaisseur de 20 nm à 500 nm.

8. Substrat revêtu selon l'une quelconque des revendications 1 à 7 comprenant deux couches résistantes à la corrosion ou plus, chaque couche comprenant de première, deuxième et troisième sous-couches telles que définies dans l'une quelconque des revendications 1 à 7.

9. Substrat revêtu selon l'une quelconque des revendications 1 à 8 dans lequel la couche conductrice comprend en outre du Ti ou des oxydes, des oxynitrures et/ou des nitrures de celui-ci.

10. Substrat revêtu selon l'une quelconque des revendications 1 à 9 dans lequel l'épaisseur totale de la couche germe, des une ou plusieurs couches résistantes à la corrosion et de la couche conductrice est de 180 nm à 9 000 nm.

11. Substrat revêtu selon l'une quelconque des revendications 1 à 10 dans lequel le substrat est choisi parmi un composant électrolyseur, une plaque bipolaire, un collecteur de courant et une couche de transport poreuse.

12. Procédé de fabrication d'un substrat revêtu selon l'une quelconque des revendications 1 à 11, le procédé comprenant le dépôt sur le substrat dans l'ordre :
a) d'une couche germe comprenant du Ti ou des oxydes de celui-ci ;
b) d'une ou de plusieurs couches résistantes à la corrosion comprenant du Ti, du Nb ou des oxydes de ceux-ci, chaque couche comprenant de première, deuxième et troisième sous-couches dans lequel la quantité de Ti augmente de la première à la troisième sous-couche et la quantité de Nb diminue de la première à la troisième sous-couche ; et
c) d'une couche conductrice comprenant du Nb, ou des nitrures et/ou des oxydes de celui-ci.

13. Électrolyseur comprenant un substrat revêtu selon l'une quelconque des revendications 1 à 11.
